(19) Europäisches Patentamt
European Patent Office
Office européen des brevets

(11) **EP 4 654 266 A1**

(12) **EUROPEAN PATENT APPLICATION**
published in accordance with Art. 153(4) EPC

(43) Date of publication:
26.11.2025  Bulletin 2025/48

(51) International Patent Classification (IPC):
*H01L 29/78* (2006.01)     *H01L 21/336* (2006.01)
*H01L 29/12* (2006.01)     *H01L 29/739* (2006.01)

(21) Application number: 24810714.6

(22) Date of filing: 29.03.2024

(52) Cooperative Patent Classification (CPC):
H10D 12/00; H10D 30/021; H10D 30/60;
H10D 62/81

(86) International application number:
PCT/JP2024/013139

(87) International publication number:
WO 2024/241706 (28.11.2024 Gazette 2024/48)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 19.05.2023  JP 2023083061

(71) Applicant: **Hitachi, Ltd.**
**Tokyo 100-8280 (JP)**

(72) Inventor: **WATANABE, Naoki**
**Tokyo 100-8280 (JP)**

(74) Representative: **Manitz Finsterwald**
**Patent- und Rechtsanwaltspartnerschaft mbB**
**Martin-Greif-Straße 1**
**80336 München (DE)**

(54) **SEMICONDUCTOR DEVICE AND MANUFACTURING METHOD FOR SAME**

(57)  Provided is a technique capable of improving a trade-off relationship between reduction in on-resistance and reduction in turn-off loss. On the premise that a low carbon vacancy density region 20 having a low carbon vacancy density is formed on the upper surface side of the drift region 4 and a high carbon vacancy density region 30 having a high carbon vacancy density is formed on the lower surface side of the drift region 4, the position of an isodensity line 100 that is included in a boundary region 40 between the low carbon vacancy density region 20 and the high carbon vacancy density region 30 and has a carbon vacancy concentration corresponding to a density of 1/2 of the carbon vacancy density of the high carbon vacancy density region 30 is located deeper than an end portion 200 of a depletion layer that extends to the drift region 4 when the IGBT is turned off.

*FIG. 1*

EP 4 654 266 A1

## Description

Technical Field

The present invention relates to a semiconductor device and a method for manufacturing the same, and relates to, for example, a technology effective for application to a semiconductor device having an insulated gate bipolar transistor and a method for manufacturing the same.

Background Art

In order to save energy in power electronics devices, low-loss power semiconductor elements using wide-gap semiconductor materials such as silicon carbide (SiC), gallium nitride (GaN), and diamond have been studied. Silicon carbide and gallium nitride have a dielectric breakdown field strength about 10 times higher than that of silicon (Si), so that the film thickness of the drift region can be 1/10 of that of silicon in the case of a power semiconductor element having the same withstand voltage. By making the drift region thin in this manner, the resistance value in the drift region can be greatly reduced, so that the on-resistance of the entire element can be reduced.

As application targets of the wide-gap semiconductor material, there are a Schottky Barrier Diode (SBD) and a Metal Oxide Field Effect Transistor (MOSFET) which are unipolar elements, a pn junction diode and an insulated gate bipolar transistor (IGBT) which are bipolar elements, and the like. In particular, a bipolar element using silicon carbide can be expected as an element that realizes low conduction loss in ultra-high withstand voltage applications exceeding 6.5 kV.

In silicon carbide, the minority carrier lifetime in the material in the growth end state (as-grown state) of the epitaxial crystal layer is significantly shorter than that in silicon. Therefore, for the purpose of improving the conductivity modulation effect in the bipolar element and reducing the resistance during the on-operation, a step of increasing the minority carrier lifetime of the drift region is performed at the time of manufacturing the element. On the other hand, when the minority carrier lifetime in the entire drift region is long, a large amount of residual carriers is discharged during the turn-off operation in which the element switches from the on state to the off state, resulting in increased turn-off loss. Therefore, the on-voltage and the turn-off loss can be reduced by a "local lifetime control structure" in which only the minority carrier lifetime on the collector side in the drift region is locally short.

PTL 1 describes an element in which an end portion of a depletion layer formed in a drift region when an operating voltage is applied is present in a region having a short minority carrier lifetime.

In addition, PTL 2 describes a method in which, when a region for extending the minority carrier lifetime is formed inside a silicon carbide epitaxial layer, the thickness of the region is made thicker than that of the other region of the epitaxial layer by using a method of arbitrarily changing the depth at which the carrier lifetime extension region reaches from the implantation surface of the silicon carbide epitaxial layer by changing the annealing temperature or the annealing time of annealing for diffusing and activating carbon atoms ion-implanted into the silicon carbide epitaxial layer.

Citation List

Patent Literature

    PTL 1: JP 3622405
    PTL 2: JP 2021-19157 A

Summary of Invention

Technical Problem

However, in PTL 1 described above, a region having a short minority carrier lifetime is present in the depletion layer. Since there are no residual carriers in the depletion layer, even if the minority carrier lifetime of the depletion layer is short, the suppression of the turn-on loss is not affected, but on the other hand, since an increase in the on-resistance is caused, the trade-off relationship between the on-resistance and the turn-off loss is deteriorated.

In addition, since there is no description of the relationship between the carrier lifetime extension region and the depletion layer in PTL 2 described above, there is a possibility that the trade-off relationship between the on-resistance and the turn-off loss is deteriorated similarly to PTL 1 described above.

In view of the above problems, an object of the present invention is to provide a technique capable of improving a trade-off relationship between reduction in on-resistance and reduction in turn-off loss.

Solution to Problem

A semiconductor device according to an embodiment is a semiconductor device including an insulated gate bipolar transistor, in which the insulated gate bipolar transistor has a drift region of a first conductivity type, and the drift region includes silicon carbide as a constituent material. Here, the drift region includes a first region having a carbon vacancy density of a first density, a second region having a carbon vacancy density of a second density higher than the first density, and a boundary region that is sandwiched between the first region and the second region, has a higher carbon vacancy density than the first region, and has a lower carbon vacancy density than the second region. At this time, the position of the isodensity line that is included in the boundary region and has a carbon vacancy concentration corresponding to a density of 1/2 of the second density is located deeper than an end portion of a depletion layer that extends to the drift region when the insulated gate bipolar transistor is turned off.

A method for manufacturing a semiconductor device according to one embodiment is a method for manufacturing a semiconductor device including an insulated gate bipolar transistor in which the end portion of the depletion layer that extends at the time of turn-off remains inside the drift region. Here, the method for manufacturing a semiconductor device includes the steps of: (a) forming a drift region of a first conductivity type that includes silicon carbide as a constituent material; (b) introducing carbon atoms into an upper surface of the drift region; and (c) diffusing the carbon atoms into the drift region.

Also, after the step (c), the drift region includes: a first region having a carbon vacancy density of a first density; a second region having a carbon vacancy density of a second density that is higher than the first density; and a boundary region that is sandwiched between the first region and the second region, has a higher carbon vacancy density than the first region, and has a lower carbon vacancy density than the second region. At this time, the position of an isodensity line that is included in the boundary region and has a carbon vacancy concentration corresponding to a density of 1/2 of the second density is located deeper than an end portion of a depletion layer that extends at the time of turn-off.

Advantageous Effects of Invention

According to one embodiment, it is possible to improve both reduction in the on-voltage and reduction in the turn-off loss, which are in a trade-off relationship with each other.

Brief Description of Drawings

[FIG. 1] FIG. 1 is a diagram showing an active cell of an IGBT in an embodying mode.
[FIG. 2] FIG. 2 is a diagram illustrating a manufacturing process of a semiconductor device in an embodying mode.
[FIG. 3] FIG. 3 is a diagram illustrating the manufacturing process of the semiconductor device subsequent to FIG. 2.
[FIG. 4] FIG. 4 is a diagram illustrating the manufacturing process of the semiconductor device subsequent to FIG. 3.
[FIG. 5] FIG. 5 is a diagram illustrating the manufacturing process of the semiconductor device subsequent to FIG. 4.
[FIG. 6] FIG. 6 is a diagram illustrating the manufacturing process of the semiconductor device subsequent to FIG. 5.
[FIG. 7] FIG. 7 is a diagram illustrating the manufacturing process of the semiconductor device subsequent to FIG. 6.
[FIG. 8] FIG. 8 is a diagram illustrating a modification in terms of manufacturing.
[FIG. 9] FIG. 9 is a graph showing a simulation result of temporal changes in current and voltage at the time of turn-off in each case where the lifetime of minority carriers in a high carbon vacancy density region, which is a "local lifetime control structure", is changed.
[FIG. 10] FIG. 10 is a diagram illustrating a first modification in structure.
[FIG. 11] FIG. 11 is a diagram illustrating a second modification in structure.
[FIG. 12] FIG. 12 is a diagram illustrating a third modification in structure.

Description of Embodiments

In all the drawings for describing the embodiments, the same members are denoted by the same reference numerals in principle, and repeated description thereof will be omitted. Note that hatching may be applied even in a plan view for easy understanding of the drawings.

In the present embodiment, a semiconductor device including an insulated gate bipolar transistor having an n-type channel structure in which a drift region and an emitter region are composed of an n-type semiconductor region and a body region is composed of a p-type semiconductor region will be described as an example. However, it is evident that the technical concept of the present embodiment can also be applied to an insulated gate bipolar transistor having a p-type channel structure in which the conductivity type is inverted.

<Study by Present Inventor>

In an insulated gate bipolar transistor (hereinafter, it may be referred to as an IGBT), when a gate voltage equal to or higher than a threshold voltage is applied to a gate electrode to turn on the IGBT, holes as minority carriers are implanted from a collector region into a drift region. As a result, in the drift region, electrons as majority carriers are implanted from the emitter region to the drift region so as to be attracted to the implanted holes. As a result, a conductivity modulation phenomenon occurs in the drift region, and the on-resistance of the IGBT is reduced.

On the other hand, in the IGBT, when a gate voltage smaller than a threshold value is applied to the gate electrode to turn the IGBT from on to off, electrons and holes implanted into the drift region are all swept out to the outside of the drift region, and then the IGBT is turned off. That is, in the IGBT, when the IGBT is turned off, it is necessary to sweep out all the electrons and holes implanted into the drift region to the outside of the drift region, and the IGBT is turned off after a tail current caused by this sweeping flows.

In the IGBT operating in this manner, the on-resistance can be reduced as the lifetime of the holes, which are minority carriers, is increased. This is because when the lifetime of the holes implanted into the drift region is long, the number of holes for attracting electrons can be increased, and as a result, the number of electrons attracted to the drift region is increased, so that the on-resistance is reduced. Therefore, in order to reduce the on-resistance of the IGBT, it is desirable to lengthen the lifetime of the holes.

On the other hand, when the IGBT is turned off, a turn-off loss occurs. The tail current causes this turn-off loss. Therefore, in order to reduce the turn-off loss, it is necessary to reduce the tail current. This tail current is a current generated when all the electrons and holes implanted into the drift region are swept out to the outside of the drift region, and the shorter the lifetime of the holes is, the more the tail current can be reduced. This is because a shorter lifetime of the holes increases the number of holes that disappear before being swept out to the outside of the drift region increases, and as a result, the number of holes swept out to the outside of the drift region decreases, which means that the tail current is reduced.

As described above, in the IGBT, the on-resistance can be reduced when the lifetime of the holes is longer, and the turn-off loss can be reduced when the lifetime of the holes is shorter. That is, in the IGBT, the reduction in the on-resistance and the reduction in the turn-off loss are in a trade-off relationship with each other. Therefore, the present inventor has studied improvement for achieving both reduction in the on-resistance and reduction in the turn-off loss, which are in a trade-off relationship with each other.

For example, the drift region can be formed by using an epitaxial growth method, but in an IGBT using silicon carbide as a constituent material, it is known that the lifetime of holes in the drift region in an "as-grown state" is significantly shorter than that of an IGBT using silicon as a constituent material. Therefore, when the drift region in the "as-grown state" is used as it is, since the lifetime of holes is short, the turn-off loss can be reduced, but the on-resistance is increased. Therefore, in the IGBT using silicon carbide as a constituent material, it is not desirable to use the drift region in the "as-grown state" as it is.

In this regard, carbon vacancies are present in the drift region using silicon carbide as a constituent material. The carbon vacancy functions as a trap level for capturing holes. As such, in the drift region having a high carbon vacancy density, the trap level for capturing holes increases, so that the lifetime of holes is shortened. In other words, in the drift region having a low carbon vacancy density, the trap level for capturing holes decreases, and thus the lifetime of holes increases.

In view of the above, it is conceivable to fill carbon vacancies with introduced carbon by introducing carbon into the drift region in the "as-grown state". In this case, carbon vacancies functioning as the trap level for capturing holes can be reduced, and as a result, the lifetime of holes can be extended. That is, the present inventor has studied extending the lifetime of holes by introducing carbon into the drift region. This is because the on-resistance of the IGBT can be reduced when the lifetime of the holes can be lengthened.

However, when carbon is introduced over the entire drift region, the lifetime of holes is lengthened in the entire drift region, leading to an increase in turn-off loss. Therefore, in order to balance the reduction in the on-resistance and the reduction in the turn-off loss, which are in a trade-off relationship with each other, it is important to define the depth at which carbon is introduced into the drift region.

That is, on the premise that the low carbon vacancy density region, in which carbon is introduced to reduce the carbon vacancy density, and the high carbon vacancy density region, in which carbon is not introduced to increase the carbon vacancy density while maintaining the "as-grown state", are provided in the drift region, it is important to determine a position (depth) at which the depth of the boundary region between the low carbon vacancy density region and the high carbon vacancy density region is defined.

In this regard, the present inventor has found, as a new finding, that it is important to define the relationship with the end portion of the depletion layer that extends to the drift region when the IGBT is turned off in order to improve both the reduction in the on-resistance and the reduction in the turn-off loss, which are in a trade-off relationship with each other, in defining the depth of the boundary region.

For example, consider a case where the depth of the boundary region described above is at a position shallower than the end portion of the depletion layer that extends to the drift region when the IGBT is turned off. In this case, the low carbon vacancy density region is narrowed, which is disadvantageous from the viewpoint of reducing the on-resistance. On the other hand, in the depletion layer, residual carriers are swept out by the electric field in the depletion layer and are not present. Therefore, even if there is a high carbon vacancy density region with a short lifetime of holes in the depletion layer, the presence of the high carbon vacancy density region in the depletion layer does not affect the improvement of the turn-off loss.

That is, from the viewpoint of improving both the reduction in the on-resistance and the reduction in the turn-off loss, which are in a trade-off relationship with each other, a configuration in which the depth of the boundary region is shallower than the end portion of the depletion layer is not appropriate.

Therefore, in the present embodiment, in order to improve both the reduction in the on-resistance and the reduction in the turn-off loss, which are in a trade-off relationship with each other, the depth of the boundary region between the low carbon vacancy density region and the high carbon vacancy density region is appropriately defined in terms of the relationship with the end portion of the depletion layer. Hereinafter, the technical idea of this devised embodiment will be described.

<Basic Idea in Embodiment>

The basic idea in the present embodiment is based on the premise that, in an IGBT using silicon carbide as a constituent material, a low carbon vacancy density region, in which carbon is introduced to lower the carbon vacancy density, and a high carbon vacancy density region, in which carbon is not introduced to maintain an "as-grown state" to increase the carbon vacancy density, are provided in the drift region. The basic idea is that the position of the boundary region between the low carbon vacancy density region and the high carbon vacancy density region is present at a position deeper than the end portion of the depletion layer that extends to the drift region when the IGBT is turned off.

According to this basic idea, since the thickness of the low carbon vacancy density region having a long hole lifetime can be increased, the on-resistance of the IGBT can be reduced. On the other hand, in the basic idea, since the high carbon vacancy density region having a short hole lifetime is provided in a layer lower than the depletion layer, the turn-off loss caused by the tail current can be reduced by adjusting the thickness of the high carbon vacancy density region. That is, according to the basic idea, by setting the position of the boundary region at a position deeper than the end portion of the depletion layer, it is possible to improve both the reduction in the on-resistance and the reduction in the turn-off loss, which are in a trade-off relationship with each other.

Hereinafter, an embodying mode embodying the basic idea will be described.

<Embodying Mode>

<<Configuration of Semiconductor Device>>

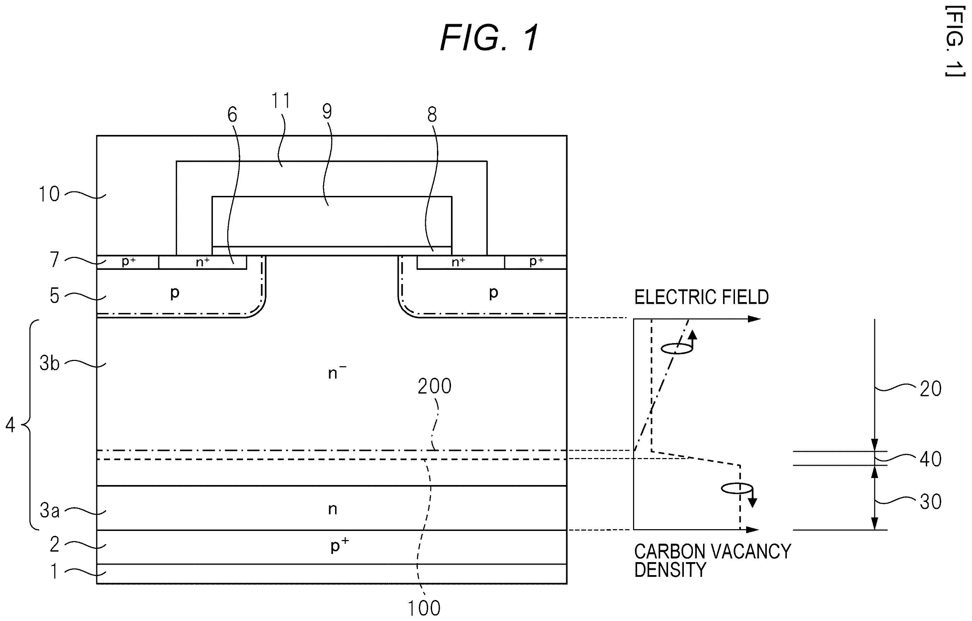

FIG. 1 is a cross-sectional view schematically illustrating an active cell of an "n-channel SiC-IGBT" (hereinafter, may be abbreviated as IGBT) included in a semiconductor device in an embodying mode.

In FIG. 1, the IGBT has an n-type drift region 4 including n-type impurities (donors) such as nitrogen and phosphorus, and the drift region 4 includes silicon carbide as a main constituent material. The drift region 4 includes, for example, a buffer region 3a and a low-concentration drift region 3b, and the buffer region 3a is formed in a layer below the low-concentration drift region 3b. That is, the drift region 4 includes the low-concentration drift region 3b and the buffer region 3a which is located in a layer below the low-concentration drift region 3b, is in contact with the low-concentration drift region 3b, and has a higher impurity concentration than the low-concentration drift region 3b. The buffer region 3a is not necessarily required, but is provided to improve the withstand voltage of the IGBT and suppress the conduction loss (reducing the on-resistance of the IGBT).

A $p^+$ type collector region 2 is provided in a layer below the buffer region 3a, and a collector electrode 1 is provided in a layer below the $p^+$ type collector region 2. The $p^+$ type collector region 2 includes, for example, a p-type semiconductor region including p-type impurities such as aluminum and boron.

Next, a body region 5, which is a p-type semiconductor region including aluminum, boron, or the like, is formed inside the low-concentration drift region 3b, and an $n^+$ type emitter region 6 including nitrogen, phosphorus, or the like is formed inside the body region 5. A body contact region 7 having a higher impurity concentration than the body region 5 is formed in the contact opening of the body region 5.

Subsequently, a gate insulating film 8 is formed so as to cover the $n^+$ type emitter region 6, the body region 5, and the low-concentration drift region 3b, and a gate electrode 9 is provided so as to cover the gate insulating film 8. An emitter electrode 10 is provided so as to cover the $n^+$ type emitter region 6 and the body contact region 7, and an interlayer insulating film 11 is formed to insulate the gate electrode 9 from the emitter electrode 10.

In the IGBT configured as described above, as a result of the drift region 4 including silicon carbide as a main constituent material, carbon vacancies are inevitably present. In the drift region 4 in the embodying mode, there is an intentional distribution in the carbon vacancy density described above.

In other words, the drift region 4 in the embodying mode includes a low carbon vacancy density region 20 having a carbon vacancy density of a first density, a high carbon vacancy density region 30 having a carbon vacancy density of a second density higher than the first density, and a boundary region 40 that is sandwiched between the low carbon vacancy density region 20 and the high carbon vacancy density region 30, has a higher carbon vacancy density than the low carbon vacancy density region 20, and has a lower carbon vacancy density than the high carbon vacancy density region 30. For example, the first density is smaller than $1 \times 10^{13}/cm^3$, and the second density is $1 \times 10^{13}/cm^3$ or more.

At this time, in the embodying mode, the low carbon vacancy density region 20 is provided in the low-concentration drift region 3b. On the other hand, the high carbon vacancy density region 30 is provided in a part of the low-concentration drift region 3b and the buffer region 3a. The position of an isodensity line 100 that is included in the boundary region 40 and has a carbon vacancy concentration corresponding to a density of 1/2 of the second density is located deeper than an end portion 200 of a depletion layer that extends to the drift region 4 when the IGBT is turned off. Here, in the embodying mode, the isodensity line 100 is present in the low-concentration drift region 3b, and the end portion 200 of the depletion layer is also present in the low-concentration drift region 3b.

For example, the graph illustrated on the right side of FIG. 1 illustrates a distribution (dotted line) in the depth direction of the carbon vacancy density included in the drift region 4, and a distribution (alternate long and short dash line) in the depth direction of the electric field generated in the drift region 4 when the IGBT is turned off in a state where the power supply voltage is applied between the collector electrode 1 and the emitter electrode 10. In the graph illustrated on the right side of FIG. 1, the low carbon vacancy density region 20 having a low carbon vacancy density extends from the upper surface side of the drift region 4. The high carbon vacancy density region 30 having a high carbon vacancy density is formed in a layer below the low carbon vacancy density region 20 with the boundary region 40 interposed therebetween. At this time, in the boundary region 40, the isodensity line 100 at which the carbon vacancy density is 1/2 of the carbon vacancy density in the high carbon vacancy density region 30 is present at a position deeper than the end portion 200 of the depletion layer in which the electric field generated in the drift region 4 is "0".

The carbon vacancy functions as a trap level that captures minority carriers (holes). Therefore, the lifetime of minority carriers in the low carbon vacancy density region 20 having a low carbon vacancy density is longer than the lifetime of minority carriers in the high carbon vacancy density region 30 having a high carbon vacancy density. As described above, the semiconductor device in the embodying mode includes the IGBT in which the drift region 4 includes regions having different minority carrier lifetimes.

<<Method for Manufacturing Semiconductor Device>>

Next, a method for manufacturing a semiconductor device in an embodying mode will be described.

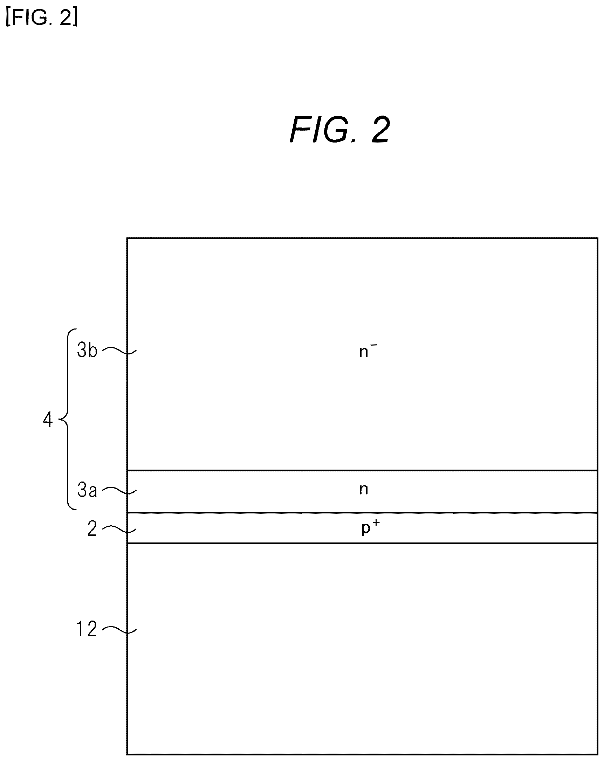

First, as shown in FIG. 2, an n-type bulk substrate 12 made of silicon carbide is prepared. Then, a $p^+$ type collector region 2, a buffer region 3a, and a low-concentration drift region 3b are sequentially grown on the upper surface of the bulk substrate 12 by an epitaxial growth method.

Here, the impurity concentration of the $p^+$ type collector region 2 is, for example, $1 \times 10^{18}/cm^3$ or more. The impurity concentration of the buffer region 3a is higher than the impurity concentration of the low-concentration drift region 3b. The impurity concentration of the low-concentration drift region 3b is, for example, less than $5 \times 10^{15}/cm^3$. The temperature in the epitaxial growth method is, for example, 1700°C or higher, and epitaxial growth is performed so that the carbon vacancy density in each of the $p^+$ type collector region 2, the buffer region 3a, and the low-concentration drift region 3b is $1 \times 10^{13}/cm^3$ or more. The film thickness of the low-concentration drift region 3b is, for example, about 50 $\mu$m or more and 100 $\mu$m or less when the withstand voltage of the IGBT is in the 6.5 kV class. For example, when the withstand voltage of the IGBT is in the 20 kV class, the film thickness of the low-concentration drift region 3b is about 180 $\mu$m or more and 250 $\mu$m or less.

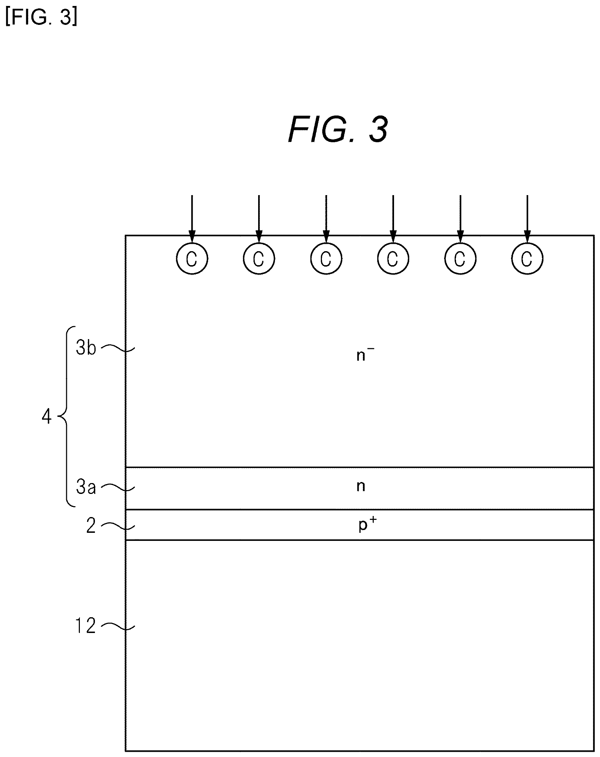

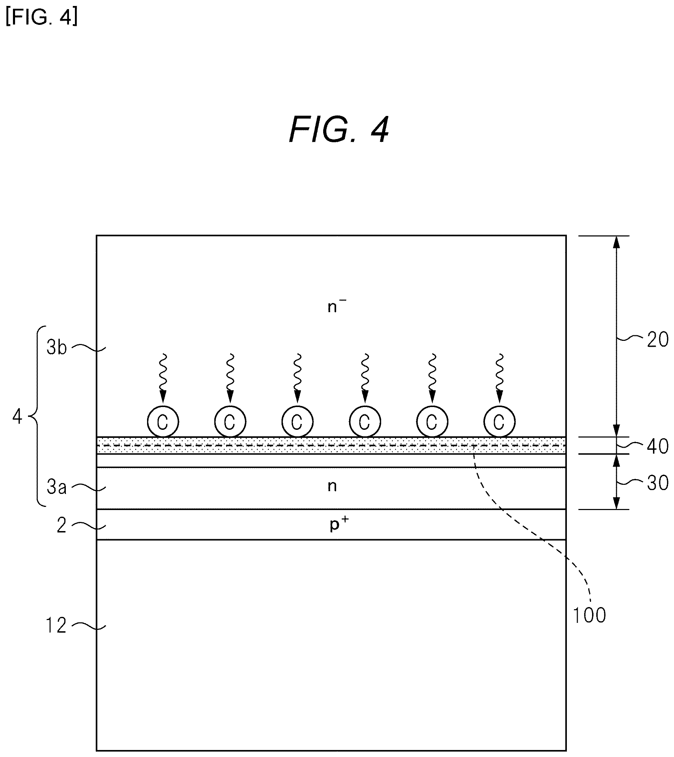

Next, as shown in FIG. 3, carbon atoms are ion-implanted from the upper surface of the low-concentration drift region 3b. The implantation amount of carbon atoms is, for example, $1 \times 10^{15}/cm^2$ or more. Thereafter, as shown in FIG. 4, carbon atoms are diffused into the low-concentration drift region 3b by heat treatment. As a result, carbon vacancies that are present in a region from the upper surface of the low-concentration drift region 3b to a predetermined depth can be filled with carbon atoms, whereby the carbon vacancy density in the region can be reduced. The temperature of the heat treatment (temperature of annealing) at this time is, for example, 1300°C or more, and the time of the heat treatment is, for example, 60 minutes or more.

In this manner, as shown in FIG. **4,** in the embodying mode, the low carbon vacancy density region 20 having a carbon vacancy density of the first density, the high carbon vacancy density region 30 having a carbon vacancy density of the second density higher than the first density, and the boundary region 40 that is sandwiched between the low carbon vacancy density region 20 and the high carbon vacancy density region 30, has a carbon vacancy density higher than that of the low carbon vacancy density region 20, and has a carbon vacancy density lower than that of the high carbon vacancy density region 30 are formed. In FIG. **4,** for example, an isodensity line 100 included in the boundary region 40, that is, an isodensity line 100 at which the carbon vacancy concentration corresponds to a density of 1/2 of the second density is illustrated.

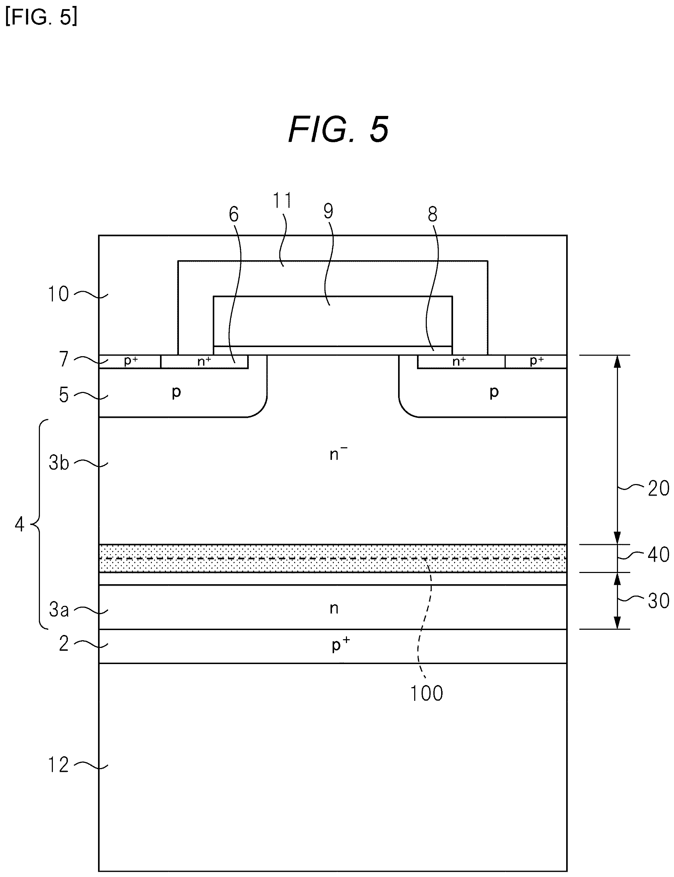

Subsequently, as illustrated in FIG. 5, each of a body region 5, an $n^+$ type emitter region 6, and a body contact region 7 is formed on the upper surface of the low-concentration drift region 3b by, for example, an ion implantation method using a photoresist as a patterning mask. The impurity concentration of the body region 5 is, for example, about $2 \times 10^{16}/cm^3$ to $2 \times 10^{18}/cm^3$. Each of the $n^+$ type emitter region 6 and the body contact region 7 is formed, for example, by implanting a conductive impurity at a high concentration so that the impurity concentration is $1 \times 10^{19}/cm^3$ or more. Then, for example, a protective film made of carbon is formed on the surface, and then, for example, heat treatment is performed at 1700°C to 1900°C to activate the conductivity type impurity introduced by the ion implantation method.

Next, for example, after the protective film is removed by oxygen plasma processing or the like, a gate insulating film 8 is formed on the low-concentration drift region 3b by, for example, forming a silicon oxide film by a wet oxidation method, a dry oxidation method, or a chemical vapor deposition (CVD) method.

Subsequently, a gate electrode 9 is formed by a method such as forming a polysilicon film immediately above the gate insulating film 8 by the CVD method after forming the gate insulating film 8, or forming an amorphous silicon film by the CVD method and then modifying the amorphous silicon film into a polysilicon film by heat treatment. Then, after an interlayer insulating film 11 made of a silicon oxide film is formed by the CVD method, a contact portion is opened in the interlayer insulating film 11 by using, for example, a dry etching method. As a result, the n⁺ type emitter region 6 and the body contact region 7 are exposed from the interlayer insulating film 11 at the bottom of the contact portion.

Thereafter, an emitter electrode 10 made of a metal film of aluminum, titanium, nickel, or the like is formed by using, for example, a sputtering method or a metal vapor deposition method. A part of the emitter electrode 10 is embedded in the contact portion, and the emitter electrode 10 is electrically connected to the n⁺ type emitter region 6 and the body contact region 7.

Before forming the emitter electrode 10, a silicide layer covering the upper surfaces of the n⁺ type emitter region 6 and the body contact region 7 exposed at the bottom of the contact portion may be formed. The silicide layer can be formed, for example, by using a salicide technique.

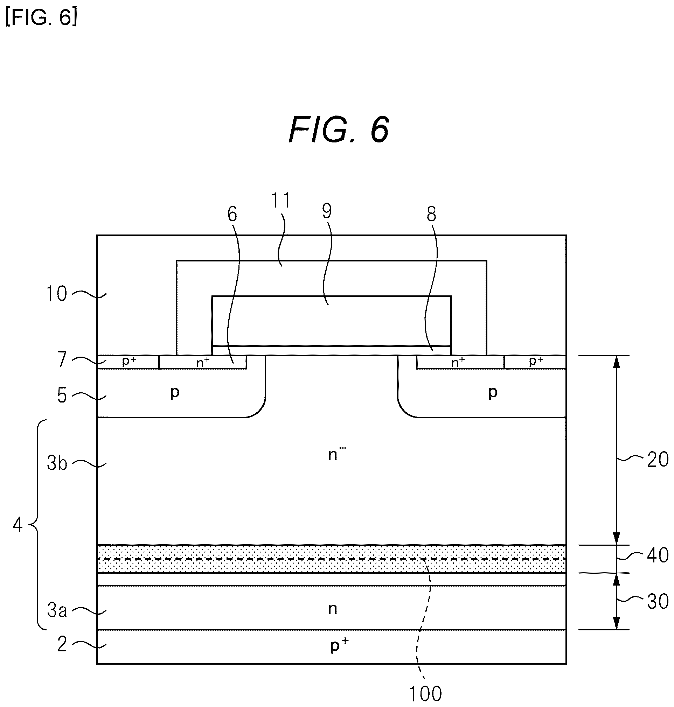

Next, as illustrated in FIG. 6, the bulk substrate 12 is removed by a grinding process to expose the lower surface of the p⁺ type collector region 2. As a result, a semiconductor substrate including the p⁺ type collector region 2, the buffer region 3a, and the low-concentration drift region 3b can be obtained.

Note that, here, an example has been described in which the bulk substrate 12 is removed after the device structure such as the gate electrode 9 on the semiconductor substrate is formed. However, in a case where the drift region 4 (epitaxial growth layer) on the bulk substrate 12 has sufficient strength, the bulk substrate 12 may be removed after the drift region 4 is formed as illustrated in FIG. 2, and then the device structure such as the body region 5 and the gate electrode 9 may be formed.

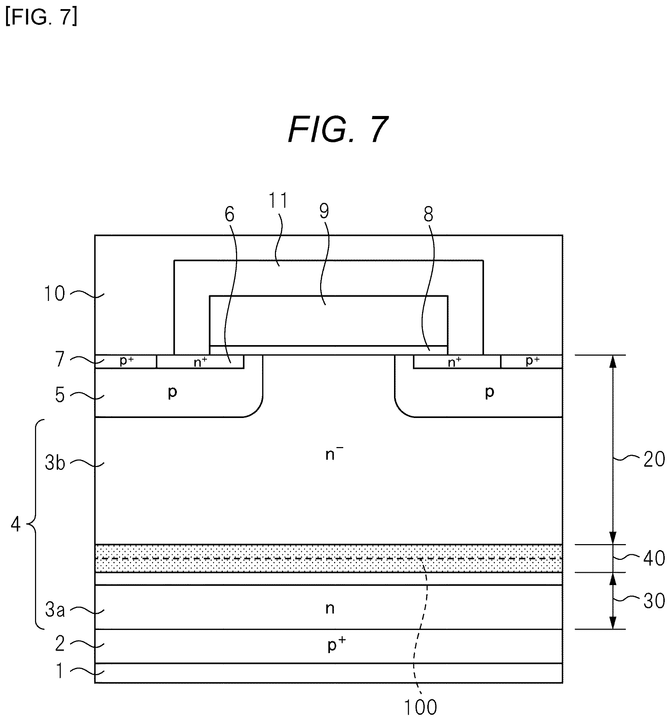

Subsequently, as illustrated in FIG. 7, a collector electrode 1 is formed on the lower surface of the p⁺ type collector region 2. The collector electrode 1 can be formed of a metal film of aluminum, titanium, nickel, gold, or the like by using, for example, a sputtering method or a metal vapor deposition method. Here, before forming the collector electrode 1, a silicide layer covering the lower surface of the p⁺ type collector region 2 may be formed. The silicide layer can be formed by, for example, a laser annealing technique.

As described above, the semiconductor device of an embodying mode can be manufactured.

A method for manufacturing the semiconductor device of the embodying mode is summarized as follows. That is, the method for manufacturing the semiconductor device of the embodying mode is a method for manufacturing the semiconductor device including an IGBT in which the end portion of the depletion layer that extends at the time of turn-off remains inside the drift region 4. At this time, the method for manufacturing the semiconductor device includes the steps of: (a) forming the n-type drift region 4 including silicon carbide as a constituent material; (b) introducing carbon atoms into the upper surface of the drift region 4; and (c) diffusing the carbon atoms into the drift region 4.

In a state where the semiconductor device after the step (c) is completed, the drift region 4 includes a low carbon vacancy density region having a carbon vacancy density of a first density, a high carbon vacancy density region having a carbon vacancy density of a second density higher than the first density, and a boundary region that is sandwiched between the low carbon vacancy density region and the high carbon vacancy density region, has a higher carbon vacancy density than the low carbon vacancy density region, and has a lower carbon vacancy density than the high carbon vacancy density region. The position of an isodensity line that is included in the boundary region and has a carbon vacancy concentration corresponding to a density of 1/2 of the second density is located deeper than an end portion of a depletion layer that extends at the time of turn-off.

<<Modification of Manufacturing Method>>

Next, a modification of the manufacturing method will be described.

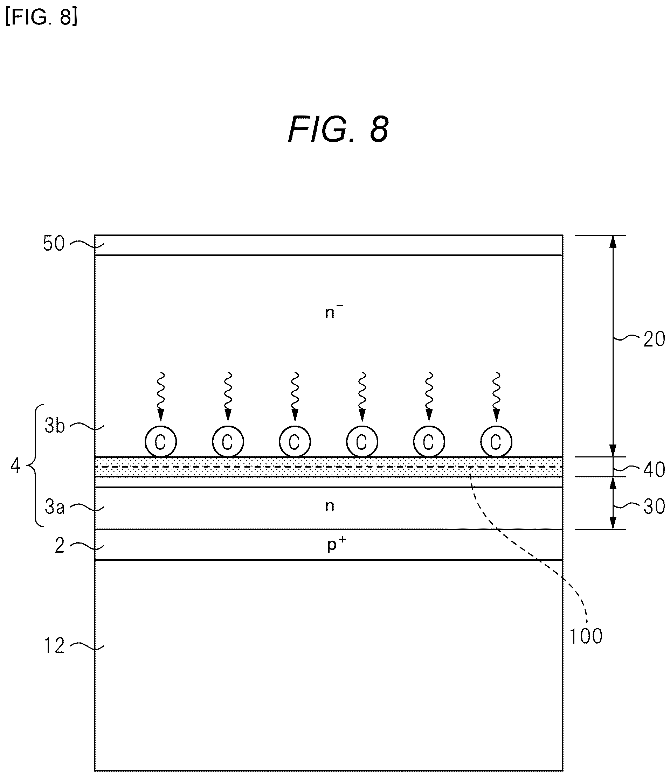

In the present modification, after the p⁺ type collector region 2, the buffer region 3a, and the low-concentration drift region 3b are sequentially grown as shown in FIG. 2, a silicon oxide film 50 is formed by a thermal oxidation method as shown in FIG. 8. In this case, silicon carbide on the upper surface side of low-concentration drift region 3b is decomposed by the thermal oxidation treatment. As a result, the silicon oxide film 50 is formed as silicon dioxide in the silicon generated by the decomposition, while the carbon generated by the decomposition is present as atoms on the upper surface side of the low-concentration drift region 3b as in FIG. 3 illustrating the embodying mode.

At the same time, by diffusing the carbon atoms by the thermal oxidation treatment, the carbon vacancies present in the region from the upper surface of the low-concentration drift region 3b to a predetermined depth are filled with the carbon atoms. As a result, the carbon vacancy density in this region decreases. The temperature of the thermal oxidation treatment is, for example, 1300°C or more, and the time of the thermal oxidation treatment is, for example, 60 minutes or more.

Thereafter, for example, hydrofluoric acid is used to remove the silicon oxide film 50, and then a device structure (element structure) is formed similarly to the above-described embodying mode.

In such a method for manufacturing a semiconductor device in the present modification, generation of carbon atoms and filling of carbon vacancies by diffusion of carbon atoms can be performed in the same thermal oxidation step. Furthermore, since the step of removing the silicon oxide film 50 is performed as a step of cleaning the substrate surface even in the embodying mode, in the present modification, the semiconductor device can be manufactured with a small number of steps.

<<Features in Embodying Mode>>

Next, feature points in the embodying mode will be described.

As illustrated in FIG. 1, for example, the feature points in the embodying mode are that, on the premise that the low carbon vacancy density region 20 having a low carbon vacancy density is formed on the upper surface side of the drift region 4 and the high carbon vacancy density region 30 having a high carbon vacancy density is formed on the lower surface side of the drift region 4, the position of an isodensity line 100 that is included in the boundary region 40 between the low carbon vacancy density region 20 and the high carbon vacancy density region 30 and has a carbon vacancy concentration corresponding to 1/2 of the carbon vacancy density of the high carbon vacancy density region 30 is at a position deeper than the end portion 200 of the depletion layer that extends to the drift region 4 when the IGBT is turned off.

Here, since the carbon vacancies serve as factors for reducing the lifetime of minority carriers in silicon carbide, the lifetime of minority carriers in the low carbon vacancy density region 20 having a small carbon vacancy density is larger than that in the high carbon vacancy density region 30 having a large carbon vacancy density.

Therefore, the presence of the low carbon vacancy density region 20 can reduce the on-resistance during the IGBT operation. On the other hand, when the IGBT is turned off, since there are no residual carriers in the depletion layer that extends to the drift region **4,** the turn-off loss is not affected as long as the low carbon vacancy density region 20 is in the depletion layer. As a result, according to the feature points in the embodying mode, the trade-off relationship between the on-resistance (on-voltage) during the IGBT operation and the turn-off loss during the turn-off of the IGBT can be improved.

For example, the depth Wd (cm) of the depletion layer formed in the IGBT when the voltage is applied can be expressed by the following formula since the difference in impurity concentration between the low-concentration drift region 3b and the body region 5 is large and the built-in voltage generated at the pn junction of silicon carbide is much smaller than the power supply voltage.

$$\mathrm{Wd} \; = \; \{\, (2 \cdot \varepsilon s \cdot \mathrm{Vcc}) \, / \, (q \cdot \mathrm{Nd}) \, \}^{0.5}$$

Here, the power supply voltage is Vcc (V), the impurity concentration of the low-concentration drift region 3b is Nd ($1/cm^3$), the charge amount of electrons is q (C), and the dielectric constant of silicon carbide is $\varepsilon s$ (F/cm).

Therefore, when the thickness of the low carbon vacancy density region 20 is W (cm), and the feature point (Wd < W) in the embodying mode and the above-described relational expression are combined, the power supply voltage Vcc for realizing the feature point satisfies the following condition.

$$\mathrm{Vcc} \; < \; \{\, (q \cdot \mathrm{Nd}) \, / \, (2 \cdot \varepsilon s) \, \} \cdot \mathrm{W}^2$$

In addition, the high carbon vacancy density region 30 serves as a region called a "local lifetime control structure" in which the lifetime of minority carriers is small. That is, in the embodying mode, the high carbon vacancy density region 30 constitutes a "local lifetime control structure".

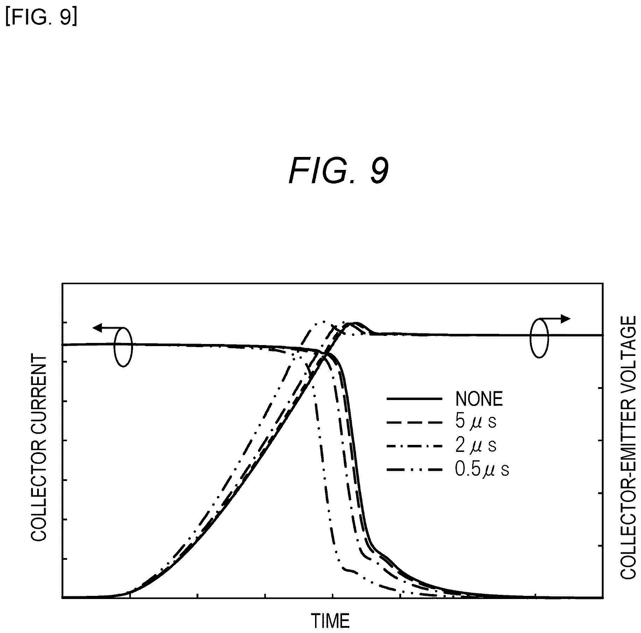

FIG. 9 is a graph showing a simulation result of temporal changes of current and voltage at the time of turn-off in each case where the lifetime of minority carriers in the high carbon vacancy density region 30 which is the "local lifetime control structure" is changed.

In a case where the lifetime of minority carriers in the high carbon vacancy density region 30 is the same as that in the low carbon vacancy density region 20, that is, in a case where there is no "local lifetime control structure", the collector current decreases with the lapse of time, but the gradient becomes gentle in the middle, and a tail current is generated.

On the other hand, when the lifetime of minority carriers in the high carbon vacancy density region 30 is reduced, in the case of 5 $\mu$s indicated by the broken line, the waveform is almost the same as that in the case where there is no "local lifetime control structure", but in the case of 2 $\mu$s indicated by the one-dot chain line or in the case of 0.5 $\mu$s indicated by the two-dot chain line, it can be seen that the tail current is reduced.

That is, by setting the lifetime of minority carriers in the high carbon vacancy density region 30 to about 2 $\mu$s or less, the effect of reducing the turn-off loss by the "local lifetime control structure" can be obtained. For this purpose, the high carbon vacancy density region 30 may have a carbon vacancy density of $1 \times 10^{13}/cm^3$ or more. In this regard, since the carbon vacancy density in the high carbon vacancy density region 30 is the same as the carbon vacancy density in the as-grown state of the epitaxial growth layer, the "local lifetime control structure" in the embodying mode can be realized by growing the epitaxial growth so that the carbon vacancy density becomes $1 \times 10^{13}/cm^3$ or more during epitaxial growth.

In the embodying mode, silicon carbide is used as a semiconductor material. In this case, the carbon vacancies that serve as factors for reducing the lifetime of minority carriers form a "deep level" of 0.63 eV from the conduction band of silicon carbide. This is deeper than a level formed by a crystal defect serving as a factor for reducing the lifetime of minority carriers in silicon. Therefore, according to the embodying mode, it is possible to reduce the turn-off loss while maintaining the "local lifetime control structure" even at a higher temperature. The IGBT is a power switching element, and is used by passing a large current. Therefore, the temperature becomes high during the operation of the IGBT. Therefore, by using silicon carbide as the semiconductor material, the effect of the "local lifetime control structure" can be obtained even at a high temperature, whereby an IGBT having a wider operation range can be obtained.

From the above, according to the feature points in the embodying mode, the trade-off between the reduction in the on-resistance and the reduction in the turn-off loss can be improved. In particular, by using silicon carbide as a semiconductor material, an effect of improving the trade-off can be obtained even at a high temperature.

<<First Modification in Structure>>

Next, a first modification will be described.

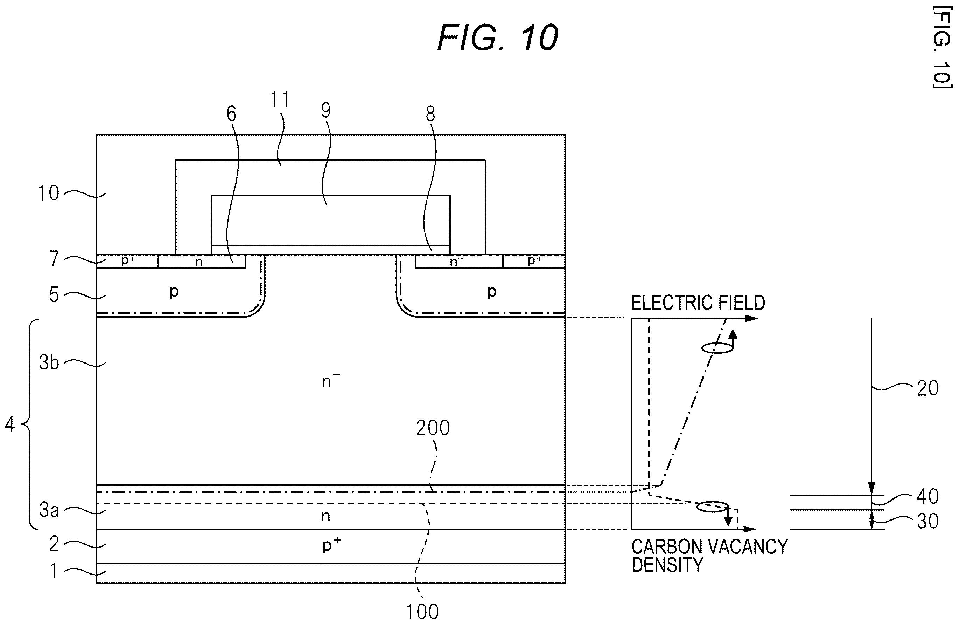

FIG. 10 is a cross-sectional view showing an active cell of an IGBT in the first modification.
A difference between the IGBT in the present first modification and the IGBT in the above-described embodying mode is that, as shown in FIG. 10, in the present first modification, the position of an isodensity line 100 having a carbon vacancy concentration corresponding to a density of 1/2 of the carbon vacancy density of the high carbon vacancy density region 30 is inside the buffer region 3a, and the end portion 200 of the depletion layer is also inside the buffer region 3a.
Such a device structure is realized by making the heat treatment temperature and the heat treatment time greater than those in the embodying mode in the heat treatment (annealing) after implanting the carbon atoms shown in FIG. 4 in the manufacturing process of the IGBT in the embodying mode and diffusing the carbon atoms to a deeper level.
In the first modification, as shown in FIG. 10, the drift region 4 includes a low-concentration drift region 3b, and a buffer region 3a that is located in a layer below the low-concentration drift region 3b, is in contact with the low-concentration drift region 3b, and has a higher impurity concentration than the low-concentration drift region 3b.
At this time, in the first modification, the low carbon vacancy density region 20 is provided in a part of the buffer region 3a and the low-concentration drift region 3b, the high carbon vacancy density region 30 is provided in the buffer region 3a, the isodensity line 100 is present in the buffer region 3a, and the end portion 200 of the depletion layer is also present in the buffer region 3a.
In the IGBT configured as described above, the gradient of the distribution in the depth direction of the electric field generated in the drift region 4 between the collector electrode 1 and the emitter electrode 10 when the IGBT is turned off is steep in the buffer region 3a having a large impurity concentration, and the expansion of the depletion layer can be suppressed even if the power supply voltage is increased. Therefore, even if the power supply voltage is increased, the position of the isodensity line 100 can be made deeper than the depth of the end portion 200 of the depletion layer. Therefore, according to the first modification, the trade-off between the reduction in the on-resistance and the reduction in the turn-off loss can be improved in the power supply voltage range larger than the power supply voltage range in the embodying mode.

<<Second Modification in Structure>>

Next, a second modification will be described.

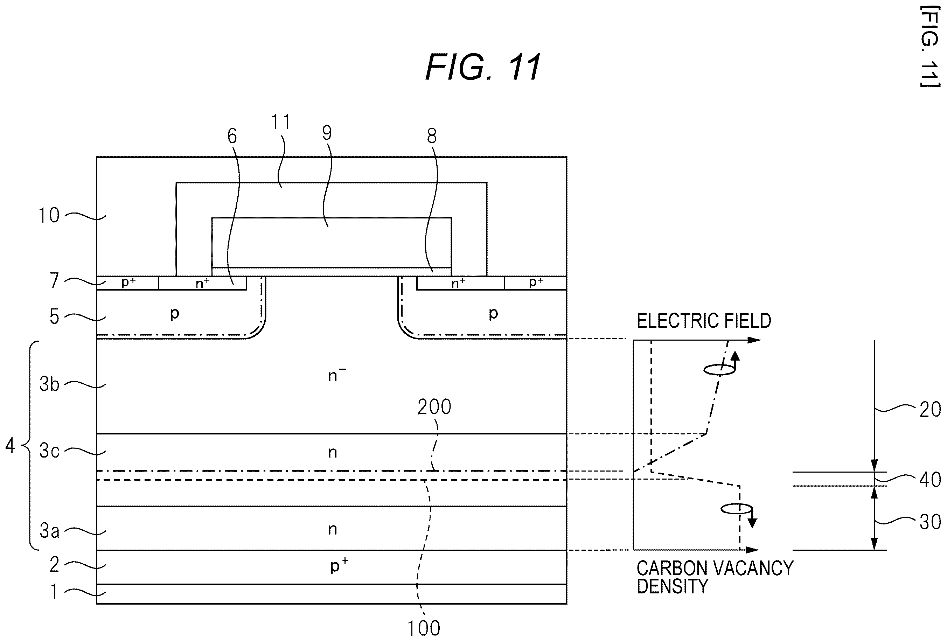

FIG. 11 is a cross-sectional view showing an active cell of an IGBT in the second modification.
The IGBT according to the second modification is different from the IGBT according to the embodying mode described above in that a high-concentration drift region 3c having a higher impurity concentration than the low-concentration drift region 3b and a lower impurity concentration than the buffer region 3a is provided between the low-concentration drift region 3b and the buffer region 3a. Further, as shown in FIG. 11, in the second modification, the position of the isodensity line 100 having a carbon vacancy concentration corresponding to a density of 1/2 of the carbon vacancy density of the high carbon vacancy density region 30 is inside the high-concentration drift region 3c, and the end portion 200 of the depletion layer is also inside the high-concentration drift region 3c.
Such a device structure can be realized by increasing the amount of source gas of impurity doping supplied when forming the low-concentration drift region 3b using the epitaxial growth method illustrated in FIG. 2 only for a first predetermined period in the manufacturing process of the IGBT in the embodying mode. Alternatively, the high-concentration drift region 3c may be grown after the buffer region 3a is formed, and then the low-concentration drift region 3b may be formed. Furthermore, when the drift region 4 on the bulk substrate 12 has sufficient strength, as shown in FIG. 5, the p$^+$ type collector region 2, the buffer region 3a, and the low-concentration drift region 3b are sequentially formed, and then the bulk substrate 12 is removed. Thereafter, for example, n-type impurities (donors) such as nitrogen and phosphorus are ion-implanted from the lower surface side (back surface side) of the p$^+$ type collector region 2 to form the high-concentration drift region 3c.
In the second modification, as shown in FIG. 11, the drift region 4 includes a low-concentration drift region 3b, a high-concentration drift region 3c that is located in a layer below the low-concentration drift region 3b, is in contact with the low-concentration drift region 3b, and has a higher impurity concentration than the low-concentration drift region 3b, and a buffer region 3a that is located in a layer below the high-concentration drift region 3c, is in contact with the high-concentration drift region 3c, and has a higher impurity concentration than the high-concentration drift region 3c.

At this time, in the second modification, the low carbon vacancy density region 20 is provided in a part of the high-concentration drift region 3c and the low-concentration drift region 3b, the high carbon vacancy density region 30 is provided in a part of the high-concentration drift region 3c and the buffer region 3a, the isodensity line 100 is present in the high-concentration drift region 3c, and the end portion 200 of the depletion layer is also present in the high-concentration drift region 3c.

In the IGBT configured as described above, the gradient of the distribution in the depth direction of the electric field generated in the drift region 4 between the collector electrode 1 and the emitter electrode 10 when the IGBT is turned off is steep in the high-concentration drift region 3c having a large impurity concentration, and the expansion of the depletion layer can be suppressed even if the power supply voltage is increased. Therefore, even if the power supply voltage is increased, the position of the isodensity line 100 can be made deeper than the depth of the end portion 200 of the depletion layer. Therefore, according to the second modification, the trade-off between the reduction in the on-resistance and the reduction in the turn-off loss can be improved in the power supply voltage range larger than the power supply voltage range in the embodying mode.

In addition, since the impurity concentration of the high-concentration drift region 3c is also low in the buffer region 3a, the gradient of the electric field in the depletion layer is gentler than that of the IGBT in the first modification described above. Therefore, the gradient of the temporal change of the voltage applied between the collector electrode 1 and the emitter electrode 10 in a state after the depletion layer reaches the high-concentration drift region 3c when the IGBT is turned off can be made gentler than that of the IGBT in the first modification. As a result, according to the second modification, it is possible to achieve an advantage that it is possible to suppress the occurrence of noise or the like due to the temporal change of the voltage.

<<Third Modification in Structure>>

Next, the third modification will be described.

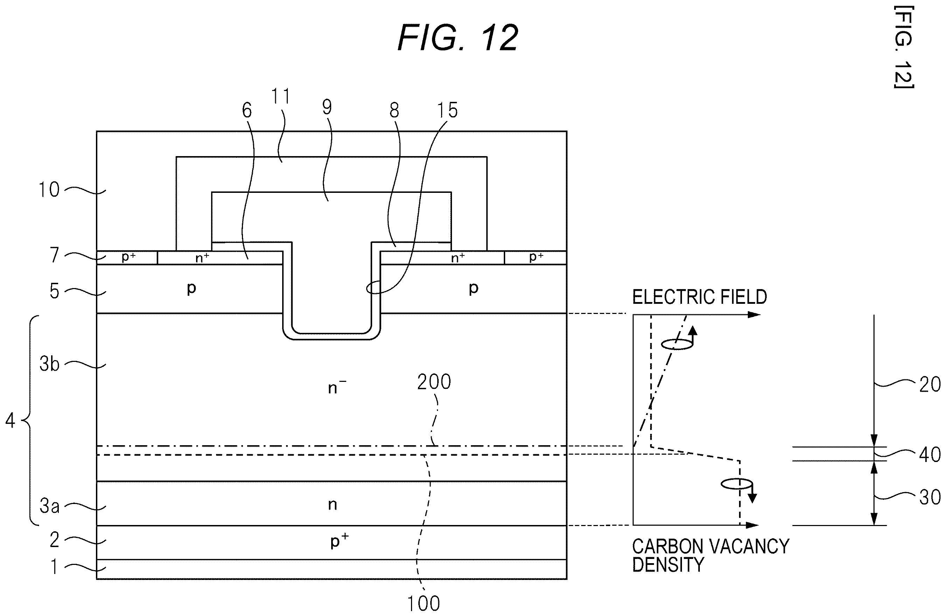

FIG. 12 is a cross-sectional view showing an active cell in the third modification.
The IGBT of the third modification is different from the IGBT of the above-described embodying mode in that a trench structure is adopted for the gate electrode 9 in the third modification. Specifically, in the third modification, as illustrated in FIG. 12, a trench 15 extending through the n+ type emitter region 6 and the body region 5 from the surface is formed. In the third modification, the gate insulating film 8 is formed so as to cover the n+ type emitter region 6 and the trench 15, and the gate electrode 9 is provided so as to cover the gate insulating film 8.

Such a device structure can be realized by forming the body region 5, the n+ type emitter region 6, and the body contact region 7, activating the conductivity type impurity introduced by the ion implantation method, and then forming the trench 15 by, for example, a dry etching method, in the manufacturing process of the IGBT in the embodying mode.

In the IGBT of the third modification, since the cell pitch can be reduced due to the trench gate structure, the channel density per unit area can be improved, and as a result, the on-resistance of the IGBT can be reduced. In addition, the crystal plane of the side surface of the trench 15 is used as the channel, and in silicon carbide, since the channel mobility on the side surface of the trench is large, the on-resistance can be further reduced by a synergistic effect with the effect of reducing the cell pitch.

Although the invention made by the present inventor has been specifically described based on the embodiment, the present invention is not limited to the embodiment, and it is evident that various modifications can be made without departing from the gist of the invention.

Reference Signs List

| | |
|---|---|
| 1 | collector electrode |
| 2 | p+ type collector region |
| 3a | buffer region |
| 3b | low-concentration drift region |
| 3c | high-concentration drift region |
| 4 | drift region |
| 5 | body region |
| 6 | n+ type emitter region |
| 7 | body contact region |
| 8 | gate insulating film |
| 9 | gate electrode |
| 10 | emitter electrode |
| 11 | interlayer insulating film |
| 12 | bulk substrate |
| 15 | trench |
| 20 | low carbon vacancy density region |
| 30 | high carbon vacancy density region |
| 40 | boundary region |
| 50 | silicon oxide film |
| 100 | isodensity line |
| 200 | end portion |

Claims

1. A semiconductor device comprising an insulated gate bipolar transistor, wherein

the insulated gate bipolar transistor includes a drift region of a first conductivity type,
the drift region includes silicon carbide as a constituent material,

the drift region includes:

a first region having a carbon vacancy density of a first density;

a second region having a carbon vacancy density of a second density that is higher than the first density; and

a boundary region that is sandwiched between the first region and the second region, has a higher carbon vacancy density than the first region, and has a lower carbon vacancy density than the second region, and

a position of an isodensity line that is included in the boundary region and has a carbon vacancy concentration corresponding to a density of 1/2 of the second density is located deeper than an end portion of a depletion layer that extends to the drift region when the insulated gate bipolar transistor is turned off.

2. The semiconductor device according to claim 1, wherein the second density is $1 \times 10^{13}/cm^3$ or more.

3. The semiconductor device according to claim 1, wherein a lifetime of minority carriers in the first region is longer than a lifetime of minority carriers in the second region.

4. The semiconductor device according to claim 1, wherein

a relationship

$$Vcc \;<\; \{(q \cdot Nd)/(2 \cdot \varepsilon s)\} \cdot W^2$$

is satisfied, where
Vcc (V) is a voltage applied between a collector and an emitter when the insulated gate bipolar transistor is turned off,
W (cm) is a thickness of the first region,
Nd ($1/cm^3$) is an impurity concentration of the first region,
q (C) is a charge amount of electrons, and
$\varepsilon s$ (F/cm) is a dielectric constant of the first region.

5. The semiconductor device according to claim 1, wherein
the drift region includes:

a low-concentration drift region; and
a buffer region that is located in a layer below the low-concentration drift region, is in contact with the low-concentration drift region, and has a higher impurity concentration than the low-concentration drift region,

the first region is provided in the low-concentration drift region,
the second region is provided in a part of the low-concentration drift region and the buffer region,
the isodensity line is present in the low-concentration drift region, and
the end portion of the depletion layer is present in the low-concentration drift region.

6. The semiconductor device according to claim 1, wherein
the drift region includes:

a low-concentration drift region; and
a buffer region that is located in a layer below the low-concentration drift region, is in contact with the low-concentration drift region, and has a higher impurity concentration than the low-concentration drift region,

the first region is provided in a part of the buffer region and the low-concentration drift region,
the second region is provided in the buffer region,
the isodensity line is present in the buffer region, and
the end portion of the depletion layer is present in the buffer region.

7. The semiconductor device according to claim 1, wherein
the drift region includes:

a low-concentration drift region;
a high-concentration drift region that is located in a layer below the low-concentration drift region, is in contact with the low-concentration drift region, and has a higher impurity concentration than the low-concentration drift region; and
a buffer region that is located in a layer below the high-concentration drift region, is in contact with the high-concentration drift region, and has a higher impurity concentration than the high-concentration drift region,

the first region is provided in a part of the high-concentration drift region and the low-concentration drift region,
the second region is provided in a part of the high-concentration drift region and the buffer region,
the isodensity line is present in the high-concentration drift region, and
the end portion of the depletion layer is present in the high-concentration drift region.

8. The semiconductor device according to claim 1, wherein the insulated gate bipolar transistor is a trench gate type insulated gate bipolar transistor.

**9.** A method for manufacturing a semiconductor device including an insulated gate bipolar transistor in which an end portion of a depletion layer that extends at a time of turn-off remains inside a drift region, the method comprising the steps of:

(a) forming a drift region of a first conductivity type that includes silicon carbide as a constituent material;
(b) introducing carbon atoms into an upper surface of the drift region; and
(c) diffusing the carbon atoms into the drift region, wherein

after the step (c),
the drift region includes:

a first region having a carbon vacancy density of a first density;
a second region having a carbon vacancy density of a second density that is higher than the first density; and
a boundary region that is sandwiched between the first region and the second region, has a higher carbon vacancy density than the first region, and has a lower carbon vacancy density than the second region, and
a position of an isodensity line that is included in the boundary region and has a carbon vacancy concentration corresponding to a density of 1/2 of the second density is located deeper than the end portion of the depletion layer that extends to the drift region at the time of turn-off.

**10.** The method for manufacturing a semiconductor device according to claim 9, wherein in the step (b), the carbon atoms are ion-implanted.

**11.** The method for manufacturing a semiconductor device according to claim 9, wherein the step (b) and the step (c) are performed by a thermal oxidation step.

**12.** The method for manufacturing a semiconductor device according to claim 9, wherein the drift region formed in the step (a) has a carbon vacancy density of $1 \times 10^{13}$ $(1/cm^3)$ or more.

[FIG. 1]

*FIG. 1*

[FIG. 2]

*FIG. 2*

[FIG. 3]

*FIG. 3*

[FIG. 4]

*FIG. 4*

[FIG. 5]

*FIG. 5*

[FIG. 6]

## FIG. 6

[FIG. 7]

*FIG. 7*

[FIG. 8]

FIG. 8

[FIG. 9]

*FIG. 9*

EP 4 654 266 A1

*FIG. 10*

[FIG. 11]

EP 4 654 266 A1

## FIG. 11

FIG. 12

[FIG. 12]

EP 4 654 266 A1

## INTERNATIONAL SEARCH REPORT

| | International application No. |
|---|---|
| | **PCT/JP2024/013139** |

**A. CLASSIFICATION OF SUBJECT MATTER**

*H01L 29/78*(2006.01)i; *H01L 21/336*(2006.01)i; *H01L 29/12*(2006.01)i; *H01L 29/739*(2006.01)i
FI: H01L29/78 652H; H01L29/78 655B; H01L29/78 652T; H01L29/78 658A; H01L29/78 658H; H01L29/78 653A; H01L29/78 655A

According to International Patent Classification (IPC) or to both national classification and IPC

**B. FIELDS SEARCHED**

Minimum documentation searched (classification system followed by classification symbols)

H01L29/78; H01L21/336; H01L29/12; H01L29/739

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2011/049054 A1 (DENSO CORPORATION) 28 April 2011 (2011-04-28) | 1-12 |
| A | JP 2014-29952 A (KABUSHIKI KAISHA TOSHIBA) 13 February 2014 (2014-02-13) | 1-12 |
| A | JP 2021-19157 A (FUJI ELECTRIC CO., LTD.) 15 February 2021 (2021-02-15) | 1-12 |
| A | WO 2015/129430 A1 (MITSUBISHI ELECTRIC CORPORATION) 03 September 2015 (2015-09-03) | 1-12 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **03 June 2024** | **11 June 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

INTERNATIONAL SEARCH REPORT
Information on patent family members

International application No.

**PCT/JP2024/013139**

| Patent document cited in search report | | | Publication date (day/month/year) | Patent family member(s) | | | Publication date (day/month/year) |
|---|---|---|---|---|---|---|---|
| WO | 2011/049054 | A1 | 28 April 2011 | JP | 2011-86883 | A | |
| JP | 2014-29952 | A | 13 February 2014 | US | 2014/0034966 | A1 | |
| | | | | CN | 103579341 | A | |
| JP | 2021-19157 | A | 15 February 2021 | (Family: none) | | | |
| WO | 2015/129430 | A1 | 03 September 2015 | US | 2016/0336390 | A1 | |
| | | | | DE | 112015001055 | T5 | |
| | | | | CN | 105900221 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3622405 B

- JP 2021019157 A